(19) Europäisches Patentamt
European Patent Office
Office européen des brevets

(11) **EP 4 318 000 A1**

(12) **EUROPEAN PATENT APPLICATION**
published in accordance with Art. 153(4) EPC

(43) Date of publication:
**07.02.2024 Bulletin 2024/06**

(21) Application number: **22871357.4**

(22) Date of filing: **30.03.2022**

(51) International Patent Classification (IPC):
**G01R 31/00** (2006.01)     **F04D 27/00** (2006.01)
**F24C 15/20** (2006.01)

(52) Cooperative Patent Classification (CPC):
**Y02B 30/70**

(86) International application number:
**PCT/CN2022/083943**

(87) International publication number:
**WO 2023/045292 (30.03.2023 Gazette 2023/13)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **26.09.2021   CN 202111131743**

(71) Applicant: **Foshan Shunde Midea Washing
Appliances
Manufacturing Co., Ltd.
Foshan, Guangdong 528311 (CN)**

(72) Inventor: **YAN, Xueping
Foshan, Guangdong 528311 (CN)**

(74) Representative: **Whitlock, Holly Elizabeth Ann et al
Maucher Jenkins
Seventh Floor Offices
Artillery House
11-19 Artillery Row
London SW1P 1RT (GB)**

(54) **RANGE HOOD AND TESTING METHOD AND TESTING APPARATUS THEREFOR**

(57)      A testing method for a range hood, the method comprising: performing constant power control on a fan of a range hood according to a set power, and obtaining M performance points to be selected of the fan and the fan efficiency corresponding to each performance point to be selected, wherein the performance points to be selected are data pairs of the air volume and air pressure of the fan when the fan efficiency meets a set condition, and $M \geq 1$ and M is an integer (S101); according to the set power and the fan efficiency, determining a target performance point from the M performance points to be selected, wherein the target performance point is a performance point to be selected that enables the energy efficiency level of the range hood to not be lower than a target level (S102); and determining a target operation parameter of the range hood according to the target performance point (S103). The development speed for improving the energy efficiency level of a whole range hood is remarkably increased, and the process cost and mounting cost are reduced. Also provided are a testing apparatus for a range hood, and a range hood.

Performing constant power control on a fan of the range hood based on a predetermined power and obtaining M to-be-selected performance points of the fan and fan efficiency corresponding to each of the M to-be-selected performance points, in which the to-be-selected performance point is a data pair of an air volume and an air pressure of the fan when the fan efficiency satisfies a predetermined condition, where $M \geq 1$ and M is an integer — S101

Selecting a target performance point from the M to-be-selected performance points based on the predetermined power and the fan efficiency, in which the target performance point is a to-be-selected performance point at which an energy efficiency level of the range hood is higher than or equal to a target level — S102

Determining a target operation parameter of the range hood based on the target performance point — S103

FIG. 1

**Description**

**CROSS-REFERENCE TO RELATED APPLICATION**

The present application claims priority to Chinese Patent Application No. 202111131743.9 filed on September 26, 2021 and entitled "RANGE HOOD AND TESTING METHOD AND APPARATUS THEREFOR", the entire disclosure of which is incorporated herein by reference.

**FIELD**

The present disclosure relates to the technical field of electrical appliances, and more particularly, to a range hood and a testing method and apparatus therefor.

**BACKGROUND**

Due to the requirements for energy conservation and emission reduction, a demand for energy efficiency levels of various household appliances continues to increase. For a range hood, an existing solution for enhancing energy efficiency is mainly implemented by improving the structure of the electrical appliance and adding an electrical device.

**SUMMARY**

The present disclosure aims to at least provide a range hood and a testing method and apparatus therefor, which at least solves technical problems of high costs and poor universality in the existing solution for improving an energy efficiency level of the range hood through structural adjustment on the range hood to some extent.

In a first aspect, the present disclosure provides a testing method for a range hood. The testing method includes: performing constant power control on a fan of the range hood based on a predetermined power and obtaining M to-be-selected performance points of the fan and fan efficiency corresponding to each of the M to-be-selected performance points, the to-be-selected performance point being a data pair of an air volume and an air pressure of the fan when the fan efficiency satisfies a predetermined condition, where $M \geq 1$ and M is an integer; selecting a target performance point from the M to-be-selected performance points based on the predetermined power and the fan efficiency, the target performance point being a to-be-selected performance point at which an energy efficiency level of the range hood is higher than or equal to a target level; and determining a target operation parameter of the range hood based on the target performance point. The constant power control method allows for a faster and more precise determination of an operation point where the fan efficiency satisfies the predetermined condition, such as an operation point achieving highest or optimal fan efficiency. Therefore, a development speed for improving the overall energy efficiency level of the range hood is significantly accelerated without requiring any structural change to the range hood, to reduce process costs and mounting costs.

In a second aspect, the present disclosure provides a testing apparatus for a range hood. The testing apparatus includes an obtaining module, a first determination module, and a second determination module. The obtaining module is configured to perform constant power control on a fan of the range hood based on a predetermined power and obtain M to-be-selected performance points of a fan of the range hood and fan efficiency corresponding to each of the M to-be-selected performance points. The to-be-selected performance point is a data pair of an air volume and an air pressure of the fan when the fan efficiency satisfies a predetermined condition, where $M \geq 1$ and M is an integer. The first determination module is configured to select a target performance point from the M to-be-selected performance points based on the predetermined power and the fan efficiency. The target performance point is a to-be-selected performance point at which an energy efficiency level of the range hood is higher than or equal to a target level. The second determination module is configured to determine a target operation parameter of the range hood based on the target performance point.

Through the constant power control method, the testing apparatus allows for the faster and more precise determination of the operation point where the fan efficiency satisfies the predetermined condition, such as the operation point with the highest or optimal fan efficiency. Therefore, the development speed of improving the overall energy efficiency level of the range hood is memorably accelerated without requiring any structural change to the range hood, to reduce the process costs and mounting costs.

In a third aspect, the present disclosure provides a testing device for a range hood. The testing device includes a memory, a processor, and a computer program stored on the memory and executable on the processor. The processor, when executing the program, implements the testing method according to any one of the implementations described above.

In a fourth aspect, the present disclosure provides a range hood including a fan and the testing device according to the implementations described above.

The present disclosure provides a testing method for a range hood. According to the testing method, constant power control is performed on the fan of the range hood, and a plurality of to-be-selected performance points at which the fan efficiency satisfies the predetermined condition is obtained under the constant power control. Further, the target performance point at which the energy efficiency level of the range hood is higher than or equal to the target level is selected from the plurality of to-be-selected performance points, to determine the target operation parameter of the range hood based on the target performance point. The predetermined condition may be the highest fan efficiency, a relatively high fan efficiency, or a fan efficiency higher than a predetermined value. The constant power control is employed to determine the to-be-selected performance points of the fan because it allows for the faster and more accurate determination of the operation point with the highest or optimal fan efficiency based on a fan efficiency algorithm and an energy efficiency level determination standard. In this way, the development speed for improving a whole energy efficiency level of the range hood is markedly expedited. After the target operation parameter is determined, operation control may be performed based on the target operation parameter during subsequent testing and user operation of the range hood, enabling the whole range hood to operate under an operation condition at the target performance point. Moreover, it ensures that the energy efficiency level of the range hood reaches the target level. In summary, the above solution improves the target level of the range hood by means of an algorithm without requirement for structural modifications on the range hood or additional control electrical appliances. Therefore, it is possible to reduce the process costs and the mounting costs, and achieve better versatility.

## BRIEF DESCRIPTION OF THE DRAWINGS

In order to clearly explain technical solutions of embodiments of the present disclosure, accompanying drawings used in description of embodiments are briefly described below. Obviously, the accompanying drawings as described below are merely some embodiments of the present disclosure. Based on these accompanying drawings, other accompanying drawings can be obtained by those skilled in the art without creative effort.

FIG. 1 is a schematic flowchart of a testing method for a range hood according to an embodiment of the present disclosure.
FIG. 2 is a schematic flowchart of a constant power control algorithm according to an embodiment of the present disclosure.
FIG. 3 is a schematic graph of an air volume versus an air pressure measured during constant power control according to an embodiment of the present disclosure.
FIG. 4 is a schematic graph of an air volume versus an air pressure measured when a range hood is subjected to constant current control in a testing stage according to an embodiment of the present disclosure.
FIG. 5 is a functional module diagram of a testing apparatus for a range hood according to an embodiment of the present disclosure.
FIG. 6 is a schematic structural diagram of a testing device for a range hood according to an embodiment of the present disclosure.

## DETAILED DESCRIPTION

In order to solve the technical problems of high costs and poor universality occurring in the existing scheme for enhancing an energy efficiency level of a range hood through structural adjustments on the range hood, embodiments of the present disclosure provide a testing method for a range hood. According to the testing method, constant power control is performed on the fan of the range hood, and a plurality of to-be-selected performance points at which the fan efficiency satisfies the predetermined condition is obtained under the constant power control. Further, the target performance point at which the energy efficiency level of the range hood is higher than or equal to the target level is determined from the plurality of to-be-selected performance points, to determine the target operation parameter of the range hood based on the target performance point. The predetermined condition may be the highest fan efficiency, a relatively high fan efficiency, or a fan efficiency higher than a predetermined value. The constant power control is employed to determine the to-be-selected performance points of the fan because it allows for the faster and more accurate determination of the operation point with the highest or optimal fan efficiency based on a fan efficiency algorithm and an energy efficiency level determination standard. In this way, the development speed for improving a whole energy efficiency level of the range hood is markedly expedited. After the target operation parameter is determined, operation control may be performed based on the target operation parameter during subsequent testing and user operation of the range hood, enabling the whole range hood to operate under an operation condition at the target performance point. Moreover, it ensures that the energy efficiency level of the range hood reaches the target level.

In order to make the objects, technical solutions, and advantages of the present disclosure more apparent, technical solutions according to embodiments of the present disclosure will be clearly and completely described below in combination with the accompanying drawings of the embodiments of the present disclosure. Obviously, the embodiments described below are merely a part of the embodiments of the present disclosure, rather than all of the embodiments. On a basis of the embodiments of the present disclosure, all other embodiments obtained by those skilled in the art without creative effort shall fall within the scope of the present disclosure.

The energy efficiency level of the range hood may be determined based on the following determination standard.

An energy efficiency index (EEI) higher than 85 corresponds to an energy efficiency level of D.

An energy efficiency index (EEI) higher than 70 and smaller than 85 corresponds to an energy efficiency level of C.

An energy efficiency index (EEI) higher than 55 and smaller than 70 corresponds to an energy efficiency level of B.

An energy efficiency index (EEI) higher than 45 and smaller than 55 corresponds to an energy efficiency level of A.

An energy efficiency index (EEI) higher than 37 and smaller than 45 corresponds to an energy efficiency level of A+.

An energy efficiency index (EEI) higher than 30 and smaller than 37 corresponds to an energy efficiency level of A++.

An energy efficiency index (EEI) smaller than 30 corresponds to an energy efficiency level of A+++.

The energy efficiency index (EEI) in the above contents is an energy efficiency index representing the energy efficiency level.

It can be seen therefrom that the smaller the EEI, the higher the energy efficiency level of the range hood. For example, when it is desirable to reach the energy efficiency level of A+++, EEI needs to be smaller than 30.

According to the definition of EEI, its calculation method is described below:

$$\text{EEI} = \frac{\text{AEC}}{\text{SAEC}} \times 100 \qquad (1).$$

In the above formula, SAEC is standard annual energy consumption in kWh/a. AEC is annual energy consumption in kWh/a.

A calculation formula for the standard annual energy consumption (SAEC) is as follows:

$$\text{SAEC} = 0.55 \times (\text{P}_{\text{fan}} + \text{P}_{\text{other}}) + 15.3 \qquad (2).$$

In the above formula, $\text{P}_{\text{fan}}$ is a fan input power in watt (W), and $\text{P}_{\text{other}}$ is a power of other energy consumption components of the range hood in W.

Further, the annual energy consumption (AEC) is calculated as below:

$$\text{AEC} = \frac{(\text{P}_{\text{fan}} \times \text{T}_{\text{fan}} \times \text{F} + \sum \text{P}_{\text{other}} \times \text{T}_{\text{other}})}{60 \times 1000} \times 365 \qquad (3).$$

In the above formula, $\text{T}_{\text{fan}}$ is an average daily fan operation time in a unit of minute and has a value of 60. $\text{T}_{\text{other}}$ is an average daily operation time of other energy-consuming components in a unit of minute and has a value of 120.

A common energy consumption component of the range hood is an illumination lamp. Therefore, in a case where there has no other electrical component, in the formulas (2) and (3), $\text{P}_{\text{other}}$ is equivalent to $\text{P}_{\text{illumination lamp}}$, $\text{T}_{\text{other}}$ is equivalent to $\text{T}_{\text{illumination lamp}}$.

F is a time growth factor, which is related to the fan efficiency and is defined as below:

$$\text{F} = 2 - \frac{\text{FDE} \times 3.6}{100} \qquad (4).$$

In the above formula, FDE is the fan efficiency and is related to an air volume and an air pressure generated by the fan. A manner of defining the fan efficiency is as follows:

$$FDE = \frac{\text{air volume} \times \text{air pressure}}{P_{\text{fan}}} \qquad (5).$$

In the above formula, a unit of the air volume is cubic meter per hour, and a unit of the air pressure is Pa.

Research has shown that according to the formulas (1) to (5), the fan efficiency (FDE) determines the energy efficiency level of the range hood in a case where the illumination lamp has a predetermined power ($P_{\text{illumination lamp}}$). Therefore, it may be considered that in a testing condition, the higher FDE corresponding to an operation point of the fan during the operation is, the higher a nominal energy efficiency level is. Therefore, the improvement of the energy efficiency level may focus on the fan efficiency. It is necessary to determine an operation point satisfying the predetermined condition, such as an operation point with the highest fan efficiency, an operation point near a maximum value, or an operation point higher than the predetermined efficiency.

According to the formula (5), the quickest way to determine the desired operation point is to make one of variables constant. For example, a constant air volume control method or a constant air pressure control method is used. However, the estimation has validated that the constant air volume control method and the constant air pressure control method are unable to realize closed-loop control, while the corresponding power can be calculated in real time by the constant power control through a feedback current of the motor of the fan. When the input power of the fan is constant, a value of FDE is proportional to a product of the air volume and the air pressure. The greater the product of the air volume and the air pressure is, the higher FDE is. Therefore, an algorithm that makes the fan input power constant becomes important as it greatly improves the development speed for determining the desired target operation point of the fan efficiency. Hence, in the present disclosure, the desired target performance point is determined by using a constant power control solution.

In a first aspect, the present disclosure provides a testing method for a range hood, the overall idea of which is to perform constant power control on the fan of the range hood, and to determine the target performance point at which the energy efficiency level of the whole range hood is higher than or equal to the target level in a constant input power state.

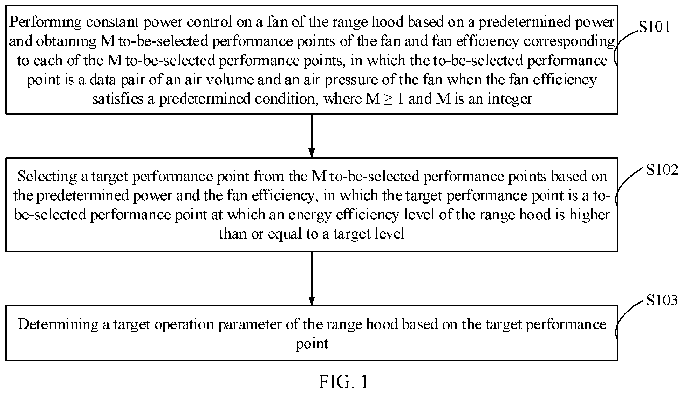

As illustrated in FIG. 1, the testing method for the range hood may include actions at block S 101, block S 102, and block S103.

At block S 101, constant power control is performed on a fan of the range hood based on a predetermined power and M to-be-selected performance points of the fan and fan efficiency corresponding to each of the M to-be-selected performance points are obtained. The to-be-selected performance point is a data pair of an air volume and an air pressure of the fan when the fan efficiency satisfies a predetermined condition.

In some embodiments, the predetermined power is predetermined, and is applied in a control input power of the fan mounted on the range hood. For different types of range hoods, as fans mounted thereon are different, the predetermined power may be determined based on the fan type specifically mounted on the range hood. For example, a fan A that is of a predetermined model and mounted in the range hood selects a predetermined power in a range of 30 W to 70 W to perform constant power control. The fan can select one or more predetermined power, which is not specifically limited herein.

After the predetermined power is determined, preparations are made to perform constant power control on the fan of the range hood. In this case, the fan is mounted on a complete machine or a prototype of the range hood. Therefore, it may be considered that the predetermined power is configured to perform constant power output on the whole range hood. A control current of the fan needs to be firstly calculated based on the predetermined power, and cannot exceed a current range of the normal operation of the fan. After the control current is acquired, the range hood is controlled based on the predetermined power and the corresponding control current.

Considering that stability of an operation state of the motor of the fan is vital to the constant power control, therefore, in some embodiments, an initial control current may be preliminarily calculated based on the predetermined power. Similarly, the initial control current maintains within the current range of the normal operation of the fan, i.e., the initial control current is greater than or equal to a minimum current for operating the fan, and is equal to or smaller than a rated current for operating the fan. After that, output control is performed on the motor of the fan based on the initial control current, and the operation state of the motor of the fan is monitored to determine whether the motor operates stably. A real-time operation current and a real-time rotational speed of the motor may be collected to determine, based on a determination of whether the real-time operation current and the real-time rotational speed satisfy the predetermined state, whether the fan operates stably. The predetermined state may be that the operation current and the rotational speed maintain stable within a predetermined time period without any change. When a monitoring result indicates that the operation state of the motor of the fan is stable, the feedback current at that moment is collected, and constant-power closed-loop control is performed based on the feedback current. When the monitoring result indicates that the operation state of the motor of the fan is unstable, the above method is repeated to perform monitoring after the initial control current is adjusted until it is confirmed that the motor of the fan operates stably. After the stable operation of the motor of the fan is monitored, a feedback electrical signal is collected for constant power control, which can increase a speed for performing constant power control and precision of constant power control.

In some embodiments, after the motor of the fan runs based on the control current and the predetermined power and the stable operation of the motor of the fan is determined, constant power control is performed. A specific method for constant power control is described below.

A feedback current and a feedback voltage of the motor are acquired. It is determined that the fan is under the constant power control based on the feedback current and the feedback voltage.

The determination whether the fan is in the constant power control state based on the feedback current and the feedback voltage is performed in two following implementations.

In a first implementation, an output power of the motor is obtained in accordance with a product of the feedback current and the feedback voltage. When the output power of the motor is kept constant, it is determined that the fan is under the constant power control. The first implementation is simplified, but has a disadvantage of poor accuracy of a determination result of the constant power.

In a second implementation, a quadrature-axis current and a direct-axis current are obtained as the feedback current, and a quadrature-axis voltage and a direct-axis voltage are obtained as the feedback voltage. An active power of the motor is calculated based on the quadrature-axis current and the quadrature-axis voltage. A reactive power of the motor is calculated based on the direct-axis current and the direct-axis voltage. A total power of the motor is calculated based on the active power and the reactive power. It is determined that the fan is under the constant power control when the total power and the predetermined power satisfy a predetermined relationship.

In some embodiments, the active power of the motor is calculated directly based on a product of the quadrature-axis current and the quadrature-axis voltage. Alternatively, an active power coefficient is introduced and the active power is calculated by a formula (6):

$$P_{active}=K_{active}\times I_Q \times U_Q \qquad (6).$$

In the above formula, the active power coefficient $K_{active}$ is a conversion coefficient between the product of the quadrature-axis current and the quadrature-axis voltage and the active power on a quadrature axis. $I_Q$ is a Q-axis current, i.e., a current of the motor on the quadrature axis. $U_Q$ is a Q-axis voltage, i.e., a voltage of the motor on the quadrature axis.

In other embodiments, the reactive power of the motor is calculated directly according to a product of the direct-axis current and the direct-axis voltage. Alternatively, a reactive power coefficient is introduced, and the reactive power is calculated by a formula (7):

$$P_{active}=K_{reactive}\times I_D \times U_D \qquad (7).$$

In the above formula, the reactive power coefficient $K_{reactive}$ is a conversion coefficient between the reactive power and the product of the current and the voltage on a straight axis. $I_D$ is a D-axis current, i.e., a current of the motor on the straight axis. $U_D$ is a D-axis voltage, i.e., a voltage of the motor on the straight axis.

Next, the total power of the motor may be calculated based on a sum of the active power and the reactive power. The total power herein is a current power to be calculated.

In order to determine whether the motor performs constant power output based on the predetermined power at this moment, it is required to determine whether the total power and the predetermined power satisfy the predetermined relationship. The predetermined relationship may satisfy that the total power is equal to the predetermined power, or that a deviation between the total power and the predetermined power is equal to or smaller than the predetermined value. For example, the deviation is 1% of the predetermined power at most.

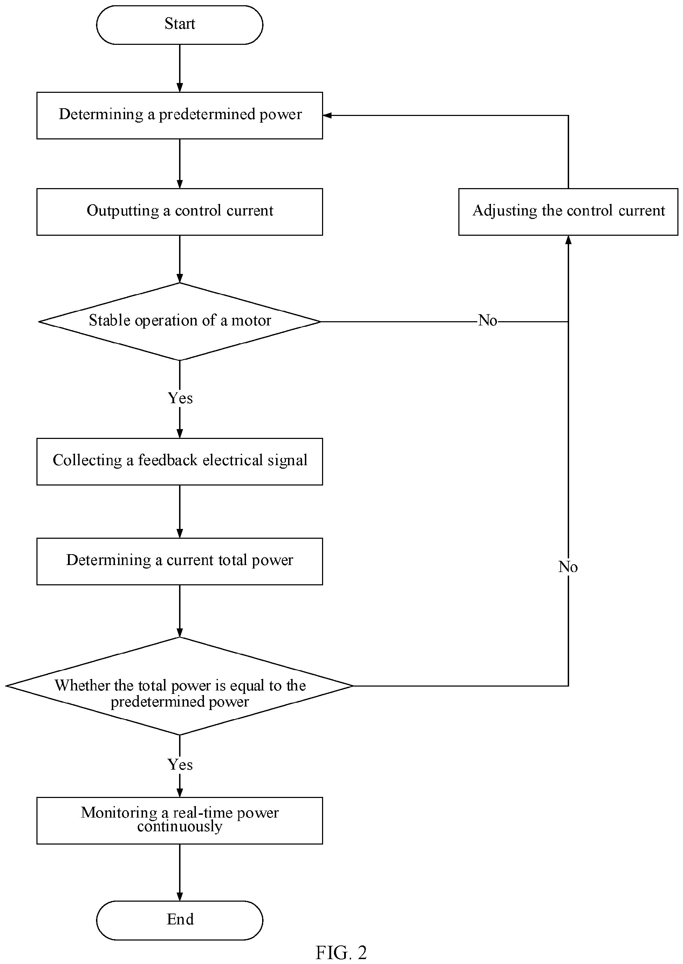

In an example, the predetermined relationship satisfies that the total power is equal to the predetermined power. In order to ensure that the motor performs constant power output in accordance with the predetermined power, it is required to make the total power calculated based on the feedback voltage and the feedback current equal to the predetermined power. When the calculated total power is equal to the predetermined power, it is determined that an output of the motor is a target power that needs to be constant. When the calculated total power is unequal to the predetermined power, a value of the control current needs to be adjusted and recalculated until the predetermined power is equal to the total power. After the constant power control is determined, the operation state of the motor is continuously monitored in real time. When a load disturbance or a change in the predetermined power occurs, the constant power control method needs to be re-started for calculation and control. A control logic for constant power control is illustrated in FIG. 2.

In general, based on a determination of whether the predetermined relationship between the total power and the predetermined power is satisfied, the constant power control of the second implementation determines whether the motor is under the constant power state by using a feedback electrical signal of the motor, such as the feedback current and the feedback voltage, as input and calculating an actual current total power of the motor. Therefore, the constant-power closed-loop control is achieved and the precision of the constant power control of the motor can be significantly increased.

After entering the constant power control, the next step is to obtain PQ performance data of the air volume Q and the air pressure P generated by the fan or the range hood under the current predetermined power. The PQ performance data includes a large amount of data pairs (Q, P) of air volumes and air pressures, and each set of data pairs includes air volume data and air pressure data corresponding to the air volume data. A testing method for PQ performance data includes performing constant power control on the fan through the predetermined power, then controlling an air duct blockage rate to change from 0% to 100%, and collecting performance data of the air volumes and the air pressures generated by the fan at different blockage rates. The fan efficiency corresponding to each set of data pairs or fan efficiency corresponding to operation points is calculated. Therefore, the to-be-selected performance points capable of enabling the fan efficiency to satisfy the predetermined condition are determined from the PQ performance data of the fan. During the calculation of the fan efficiency, each set of data pairs of the PQ performance data may be calculated by the formula (5), and the product of the air volume and air pressure is calculated and divided by the predetermined power, to obtain the fan efficiency. Alternatively, the fan efficiency may be obtained by multiplying the product of the air volume and air pressure by a fan efficiency correction coefficient and dividing it by the predetermined power.

After the fan efficiency of all the data pairs is calculated, the required to-be-selected performance points are determined based on the fan efficiency. As mentioned above, the predetermined condition may be the highest fan efficiency or the efficiency near the highest point, such as fan efficiency higher than or equal to 90% to 95% of the highest efficiency, or fan efficiency higher than an efficiency value predetermined based on experience. When the highest fan efficiency is used as the predetermined condition, there is only one to-be-selected performance point, i.e., M=1. When other fan efficiency near the highest efficiency point is taken as the predetermined condition, there is at least one to-be-selected performance point, i.e., M≥1.

In a case where the constant power control is performed based on a plurality of predetermined powers, it is only necessary to perform constant power control on each of the predetermined/testing power in accordance with the above logic, and collect the PQ performance data of the range hood at each of the plurality of predetermined powers. Therefore, to-be-selected performance points with the fan efficiency satisfying the predetermined condition are determined at different predetermined powers.

With reference to formulas (3) and (4), the higher the fan efficiency is, the higher the energy efficiency level of the range hood is. Therefore, it is determined whether the energy efficiency level of each of the to-be-selected performance points is higher than or equal to the target level by calculating the energy efficiency level of the range hood corresponding to the to-be-selected performance point.

At block S102, a target performance point is selected from the M to-be-selected performance points based on the predetermined power and the fan efficiency. The target performance point is a to-be-selected performance point at which an energy efficiency level of the range hood is higher than or equal to a target level.

In some embodiments, the energy efficiency level may be represented by EEI. During the early design of the range hood, configurations of other energy consumption devices other than the fan are unchanged, i.e., $P_{other}$ is determined. Therefore, after the fan efficiency corresponding to each of the to-be-selected performance points and the predetermined power corresponding to each of the to-be-selected performance points are obtained, the energy efficiency level of the range hood at an operation point can be calculated. The energy efficiency level may be calculated in two manners.

In a first manner, the energy efficiency level is calculated by the formulas (1), (2), (3), and (4).

In a second manner, SAEC is calculated by a formula (8):

$$\text{SAEC} = \text{L}_1 \times [(\text{P}_{\text{fan}} + \text{P}_{\text{other}}) + \text{c}] \qquad (8).$$

In the above formula, $\text{L}_1$ is a standard annual energy consumption coefficient, and c is a constant term.

AEC is calculated in accordance with the following formula (9):

$$\text{AEC} = (\text{P}_{\text{fan}} \times \text{T}_{\text{fan}} \times \text{FDE} + \textstyle\sum \text{P}_{\text{other}} \times \text{T}_{\text{other}}) \times \text{L}_2 \qquad (9).$$

In the above formula, $\text{L}_2$ is an annual energy consumption coefficient.

After SAEC and AEC are calculated, EEI is calculated by using the formula (1). EEI reflects the energy efficiency level of the range hood at the current performance point.

The above manners can determine the energy efficiency level corresponding to at least one to-be-selected performance point, and determine the required target operation point in accordance with the requirement that the energy efficiency level is higher than or equal to the target level. The target level may be A+++, A++, or other energy efficiency levels, and is determined based on actual development requirements of the range hood.

At block S103, a target operation parameter of the range hood is determined based on the target performance point.

After the target performance point is obtained, the target operation parameter of the range hood at the target performance point or the target operation parameter of the fan at the target performance point needs to be obtained. In a subsequent testing stage of the range hood and user's usage stage, control is performed based on the target operation parameter. In this way, the whole range hood has the energy efficiency level higher than or equal to the target level. In some embodiments, an actual operation current or an actual rotational speed of the fan when the fan operates at the target performance point is used as the target operation parameter. The actual operation current may be used for the constant current control on the range hood in the testing stage of the range hood or user's usage stage, and the actual rotational speed may be used for constant rotational-speed control on the range hood in the testing stage of the range hood or user's usage stage. In this way, the fan can be ensured to stably operate at the target performance point or near the target performance point in combination with an air duct control algorithm, enabling the overall energy efficiency of the fan to reach the required energy efficiency level.

In an example, the fan operates at the testing condition in the testing stage, to describe how to verify the energy efficiency level of the range hood after the target operation parameter is obtained. In some embodiments, after the target operation parameter of the range hood is obtained, when the range hood is tested, the constant current control is performed on the fan of the range hood based on the actual operation current, or the constant rotational-speed control is performed on the fan of the range hood based on the actual rotational speed. After entering the constant current control and the constant rotational-speed control, a second mapping relationship between an air volume and an air pressure of the range hood under the testing condition is collected. When the second mapping relationship and the target performance point satisfy a predetermined corresponding condition, it verifies that the energy efficiency level of the range hood reaches the target level.

In some embodiments, during the testing of the range hood, the actual operation current or the actual rotational speed corresponding to the target performance point is used for the constant target parameter control, and the second mapping relationship at this moment is collected. The second mapping relationship is also the performance data of the air volume-air pressure of the range hood, and its test solution is to control the air duct blockage rate within a predetermined blockage range, such as ranging from 30% to 70%. The constant target parameter control is performed on the fan of the range hood within the predetermined blockage range based on the target operation parameters, and the performance data of the air volume-air pressure in the process is collected.

Therefore, in the testing stage, it is verified whether the range hood nominates the target energy efficiency level, such as A+++. The pivotal factor is to verify whether a PQ performance curve corresponding to the second mapping relationship intersects with a PQ performance curve corresponding to a first mapping relationship at the target performance point. The target operation parameter used in the testing stage is derived from the actual operation parameter of the fan at the target performance point. Accordingly, when the target operation parameter is used to perform the constant parameter control, the collected PQ performance curve will certainly pass through the target performance point theoretically. In this way, the target performance point at which the range hood nominates the energy efficiency level is determined.

Therefore, the predetermined corresponding condition for verifying whether the energy efficiency of the range hood really reaches the target energy efficiency may be that the second mapping relationship includes the target performance point, or that a Euclidean distance between the target performance point and the second mapping relationship is smaller than or equal to a predetermined distance threshold. In this way, when the range hood is tested to operate at the testing condition, the range hood can operate stably at the target performance point and run at an optimal-efficiency operation condition point of the range hood. Therefore, the energy efficiency level of the range hood is improved. Moreover, an energy efficiency level of a product can be verified to really reach a required target level, and the range hood may be nominal to reach the target energy efficiency level. When the Euclidean distance is greater than the distance threshold, it means that a deviation between the target performance point and the second mapping relationship is great, the range hood cannot operate near the target performance point when the range hood operates at the testing condition, and the product cannot be nominal to the target energy efficiency level.

In summary, the above solution relies on a software algorithm to estimate the total power by a constant power control technology based on the feedback electrical signal of the motor, to form closed-loop control, which enables the operation of the motor to be more stable. In combination with the energy efficiency level determination standard, the constant power control is more conducive to determining the fan efficiency satisfying the predetermined condition, such as the highest efficiency or the performance point near the highest efficiency. Therefore, the target operation point of the range hood is significantly accelerated. Moreover, it is ensured that the whole range hood has a development speed greater than or equal to that of operation at the target energy efficiency level. Meanwhile, it is ensured that the range hood can operate in a state of being kept at the nominal energy efficiency level when the user uses the range hood.

Next, by taking a range hood of a predetermined model and corresponding specific values as an example, the technical solutions of the embodiments of the present disclosure are described for understanding the technical solutions of the present disclosure. However, the specific values are not used as limitation on the technical solutions of the present disclosure, and may be adjusted as desired.

In an optional embodiment, during a development stage of the range hood of the predetermined model, the energy efficiency level to be reached by the whole range hood is higher than or equal to A+++. To achieve this energy efficiency level, EEI should not exceed 30. Based on the type of the fan of the prototype, it is determined that the predetermined power is in a range of 30 W to 70 W. The predetermined condition of the to-be-selected performance point is the performance point with the highest fan efficiency.

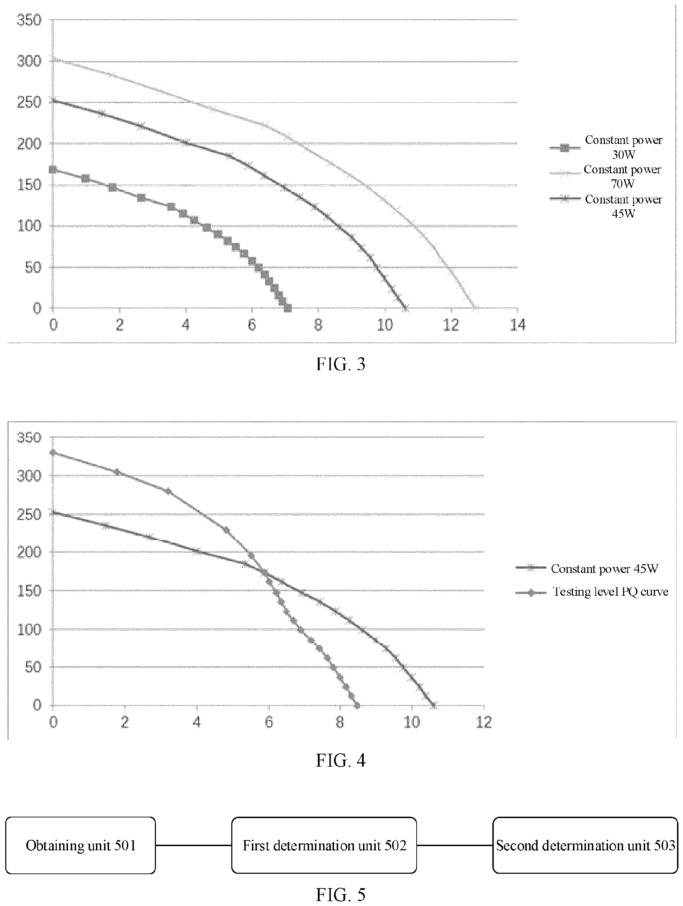

At step 1, a test is performed on the prototype at a constant power of 30 W. An "air volume-air pressure" curve is obtained by the test and shown in FIG. 3. In FIG. 3, an abscissa is the air volume in cubic meters per minute, and an ordinate is the air pressure in Pa.

At step 2, the fan efficiency FDE corresponding to each of sampling data points on the curve is calculated in accordance with the formula (5). In a curve of 30 W, a point with the highest FDE is (2.722, 168.4), and an FDE value is 25.4%. This performance point is used as the to-be-selected performance point.

A unit of the air volume in the formula (5) is cubic meters per hour by taking a calculation process of the highest efficiency point as an example. Therefore, when the air volume Q is 2.722 cubic meters per minute, the air pressure P is 168.4 Pa and the predetermined power P is 30 W, FDE is calculated to be equal to 0.254 in accordance with FDE=[ (2.722 × 60) × 168.4 ]/(30 × 60 × 60), i.e., 25.4%.

At step 3, based on the FDE value, the predetermined power and the illumination lamp power of 1.5 W, EEI is calculated to be 39.87 in combination with the formulas (1) to (4), which belongs to A+ level energy efficiency, but does not reach A+++ level energy efficiency. Therefore, the predetermined power needs to be re-determined to perform a test.

At step 4, the predetermined power is determined to be 70 W, and the processes of steps 1 to 3 are repeated. FIG. 3 illustrates the "air volume-air pressure" curve obtained by the testing. Similarly, FDE of each of the sampling points on the curve is calculated in accordance with the formula (5) to obtain a point with the highest FDE as (5.212, 283.5) and the corresponding FDE of 35.18% in a curve of 70 W. This point is used as the to-be-selected performance point. EEI is calculated to be 36.32 in combination with an illumination lamp power of 1.5 W according to the formulas (1) to (4), which belongs to A++ level energy efficiency, but does not reach A+++ level energy efficiency. Therefore, the predetermined power is selected within a range of 30 W to 70 W for testing.

At step 5, the predetermined power is determined to be 45 W. The processes of steps 1 to 3 are repeated. In this case, the "air volume-air pressure" curve obtained by testing is illustrated in FIG. 3. Similarly, FDE of each of the sampling points on the curve is calculated by the formula (5), to obtain a point with the highest FDE as (6.36, 161.33) and the corresponding FDE of 38.01% in a curve of 45 W. This point is used as the to-be-selected performance point. EEI is calculated to be 28.07 in combination with the illumination lamp power of 1.5 W according to the formulas (1) to (4), which reaches the A+++ level energy efficiency. Therefore, (6.36, 161.33) is the target performance point required by the range hood, and the current I and the rotational speed S corresponding to the target performance point are recorded.

At step 6, in order to verify that the range hood may be nominal to the A+++ level, the range hood needs to be tested at the testing condition in the testing stage. In this case, the air volume-air pressure curve of the range hood passes through the target performance point with the highest FDE (6.36,161.33) of the air volume-air pressure curve (as illustrated in FIG. 3), which is obtained by a constant power test of 45 W. Moreover, the fan efficiency FDE corresponding to the target performance point is 38%, and EEI is 28.07. The testing condition uses the current I recorded in step 5 to perform constant current control. An air volume-air pressure curve of the range hood is obtained when the range hood is tested by a testing apparatus. In FIG. 4, rhombus is used as a curve of a graphic identifier, the abscissa is the air volume in cubic meters per minute, and the ordinate is the air pressure in Pa. The air volume-air pressure curve obtained at step 6 intersects with the air volume-air pressure curve obtained at step 5 under control of the constant power of 45 W (in FIG. 4, * is used as a curve of a graphic identifier) at the target performance point (6.36, 161.33). Therefore, it is ensured that the range hood can stably operate near the intersection point during the testing, i.e., it is verified that the range hood may be identified as the A+++ level energy efficiency.

In another optional embodiment, steps 1 to 5 are the same as the foregoing embodiments.

At step 6, the range hood is tested at the testing condition in the testing stage. The testing condition uses the rotation speed S recorded in step 5 to perform constant rotational-speed control. Moreover, the air volume-air pressure curve of the range hood is measured when the testing is performed on the testing apparatus, and it is determined that the curve passes through the target performance point (6.36,161.33). In this case, EEI is calculated to be 28.07 and satisfies the standard smaller than 30, and the A+++ level energy efficiency may be nominal.

In conclusion, the above embodiments provide a testing method for a range hood. According to the testing method, constant power control is performed on the fan of the range hood, and a plurality of to-be-selected performance points at which the fan efficiency satisfies the predetermined condition is obtained under the constant power control.

Further, the target performance point at which the energy efficiency level of the range hood is higher than or equal to the target level is determined from the plurality of to-be-selected performance points, to determine the target operation parameter of the range hood based on the target performance point. The predetermined condition may be the highest fan efficiency, a relatively high fan efficiency, or a fan efficiency higher than a predetermined value. The constant power control is employed to determine the to-be-selected performance points of the fan because it allows for the faster and more accurate determination of the operation point with the highest or optimal fan efficiency based on a fan efficiency algorithm and an energy efficiency level determination standard. In this way, the development speed for improving a whole energy efficiency level of the range hood is markedly expedited. After the target operation parameter is determined, operation control may be performed based on the target operation parameter during subsequent testing and user operation of the range hood, enabling the whole range hood to operate under an operation condition at the target performance point. Moreover, it ensures that the energy efficiency level of the range hood reaches the target level. In summary, the above solution improves the target level of the range hood by means of an algorithm without requirement for structural modifications on the range hood or additional control electrical appliances. Therefore, it is possible to reduce the process costs and the mounting costs, and achieve better versatility.

As illustrated in FIG. 5, in a second aspect of the present disclosure, a testing apparatus for a range hood is provided. The testing apparatus includes an obtaining module 501, a first determination module 502, and a second determination module 503. The obtaining module 501 is configured to perform constant power control on a fan of the range hood based on a predetermined power and obtain M to-be-selected performance points of the fan and fan efficiency corresponding to each of the M to-be-selected performance points. The to-be-selected performance point is a data pair of air volumes and air pressures of the fan when the fan efficiency satisfies a predetermined condition, where $M \geq 1$ and M is an integer. The first determination module 502 is configured to select a target performance point from the M to-be-selected performance points based on the predetermined power and the fan efficiency. The target performance point is a to-be-selected performance point at which an energy efficiency level of the range hood is higher than or equal to a target level. The second determination module 503 is configured to determine a target operation parameter of the range hood based on the target performance point.

In some embodiments, the first determination module 502 is configured to determine an energy efficiency level of the range hood corresponding to each of the M to-be-selected performance points based on the predetermined power and the fan efficiency corresponding to each of the M to-be-selected performance points; and to select as the target performance point a to-be-selected point from the M to-be-selected performance points at which the energy efficiency level is higher than or equal to the target level.

In some embodiments, the obtaining module 501 is configured to acquire a control current based on the predetermined power; to acquire a feedback current and a feedback voltage of a motor of the fan by controlling, based on the control current and the predetermined power, the motor; and to determine, based on the feedback current and the feedback voltage, that the fan is under the constant power control.

In some embodiments, the obtaining module 501 is configured to run the motor of the fan based on the control current and the predetermined power; to obtain a real-time rotational speed and a real-time current of the motor; and to obtain the feedback current and the feedback voltage based on a determination that the real-time rotational speed and the real-time current satisfy a predetermined condition.

In some embodiments, the feedback current includes a quadrature-axis current and a direct-axis current, and the feedback voltage includes a quadrature-axis voltage and a direct-axis voltage. The obtaining module 501 is configured to acquire an active power of the motor based on the quadrature-axis current and the quadrature-axis voltage; to acquire a reactive power of the motor based on the direct-axis current and the direct-axis voltage; to acquire a total power of the motor based on the active power and the reactive power; and to determine, when the total power and the predetermined power satisfy a predetermined relationship, that the fan is under the constant power control.

In some embodiments, the obtaining module 501 is configured to: perform constant power control on a fan of the range hood based on a predetermined power and obtain a first mapping relationship of the fan at the predetermined power, in which the first mapping relationship includes N sets of data pairs of the air volumes and the air pressures, where $N \geq 2$ and N is an integer; to determine, based on the first mapping relationship and the predetermined power, fan efficiency associated with each of the N sets of data pairs; and to determine a data pair at which the fan efficiency satisfies the predetermined condition as the to-be-selected performance point.

In some embodiments, the predetermined power includes P testing powers, where $P \geq 2$ and P is an integer. The obtaining module 501 is configured to perform the constant power control on the fan based on each of the P testing powers, obtain a sampling dataset of the air volumes and the air pressures of the fan at each of the P testing power, and determine all the sampling datasets as the first mapping relationship. One of the sampling datasets includes a plurality of sets of data pairs of the air volumes and the air pressures.

In some embodiments, the second determination module 503 is configured to obtain an actual operation current or an actual rotational speed of the fan when the fan operates at the target performance point; and to determine the actual operation current or the actual rotational speed as the target operation parameter. The actual operation current is used for the constant current control on the range hood, and the actual rotational speed is used for constant rotational speed control on the range hood.

In some embodiments, the testing apparatus further includes a verification module, which is configured to control, based on the target operation parameter, the fan of the range hood to constantly operate at the target operation parameter; to obtain a second mapping relationship of the range hood, in which the second mapping relationship represents a relationship between the air volume and the air pressure of the range hood; and to verify that the energy efficiency level of the range hood reaches the target level when the second mapping relationship and the target performance point satisfy a predetermined corresponding condition.

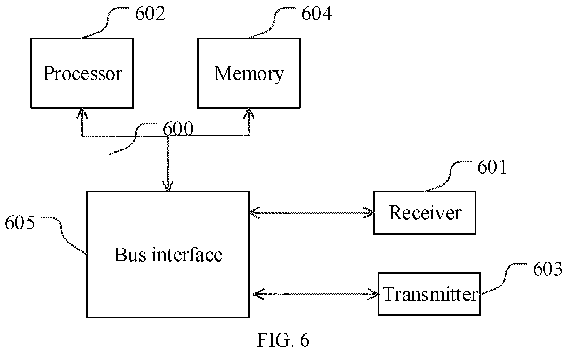

As illustrated in FIG. 6, in a third aspect of the present disclosure, a testing device for a range hood is provided. As illustrated in FIG. 6, the testing device includes a memory 604, a processor 602, and a computer program stored on the memory 604 and executable on the processor 602. The processor 602, when executing the computer program, implements the testing method according to any one of the embodiments of the first aspect.

In FIG. 6, a bus architecture (represented by a bus 600) is provided, and the bus 600 may include any number of interconnected buses and bridges. The bus 600 links various circuits including one or more processors represented by the processor 602 and a memory represented by the memory 604. The bus 600 may also link other circuits, such as a peripheral device, a voltage regulator, and a power management circuit, which are well known in the art, and therefore are not further described herein. A bus interface 605 provides an interface among the bus 600, a receiver 601, and a transmitter 603. The receiver 601 and the transmitter 603 may be the same element, i.e., a transceiver, to provide a unit for communicating with other various devices on a transmission medium. The processor 602 is responsible for managing the bus 600 and general processing, and the memory 604 may be used to store data used by the processor 602 when performing operations.

In a fourth aspect of the present disclosure, a range hood is provided, and includes a fan and the testing device according to any one of the embodiments of the third aspect. The specific implementation details of the testing device are reference to the foregoing description, and other implementation details may refer to the related art, and details thereof will not be repeated herein.

The functions described herein may be implemented in hardware, software executed by a processor, firmware, or any combination thereof. If implemented in software executed by the processor, the functions may be stored as one or more instructions or code on or transmitted over a computer-readable medium. Other examples and embodiments are within the scope and spirit of the present disclosure and the appended claims. For example, due to the nature of software, the functions described above may be implemented by using software executed by a processor, hardware, firmware, hardwired, or a combination of any of these. In addition, respective functional units in respective embodiments of the present disclosure may be integrated in one processing unit, or the respective units may be separate physical existence, or two or more units may be integrated in one unit.

In the embodiments of the present disclosure, it can be appreciated that the disclosed systems, apparatuses, and methods may be implemented in other ways. For example, the apparatus embodiments described above are illustrative only. For example, the divisions of the units are only divisions based on logical functions, and there may be other divisions in actual implementations. For example, more than one unit or component may be combined or integrated into another system, or some features can be ignored or omitted. In addition, the mutual coupling or direct coupling or communicative connection as shown or discussed may be indirect coupling or communicative connection between apparatuses or units via some interfaces which may be electrical, or in any other forms.

The units described as separate parts may or may not be physically separated. Components illustrated as units may or may not be physical units, i.e., the components may be located in a place, or may be distributed on a plurality of network units. Some or all of the units can be selected based on actual needs to achieve objects of the solutions of the embodiments.

If the functions are realized in form of functional software units and are sold or used as separate products, they can be stored in a computer readable storage medium. Based on this understanding, a part of the technical solutions or the essential parts of the technical solutions (i.e. the part making a contribution to the related art) can be embodied in form of software product, which is stored in a storage medium, and includes several instructions used for causing a computer device (for example, a personal computer, a server, or a network device) to execute all or part of steps in the methods described in respective embodiments of the present disclosure. The above storage medium may be any medium capable of storing program codes, including a USB flash disk, a Read-Only Memory (ROM), a Random Access Memory (RAM), a mobile hard disk, a disc, or a light disk.

While preferred embodiments of the present disclosure have been described above, the present disclosure is not limited thereto. For those skilled in the art, various changes and modifications can be made to the present disclosure. Any modification, equivalent replacement, improvement, etc., made within the spirit and principle of the present disclosure shall fall within the scope of the present disclosure.

**Claims**

1. A testing method for a range hood, the testing method comprising:

   performing constant power control on a fan of the range hood based on a predetermined power and obtaining M to-be-selected performance points of the fan and fan efficiency corresponding to each of the M to-be-selected performance points, the to-be-selected performance point being a data pair of an air volume and an air pressure of the fan when the fan efficiency satisfies a predetermined condition, where $M \geq 1$ and M is an integer;
   selecting a target performance point from the M to-be-selected performance points based on the predetermined power and the fan efficiency, the target performance point being a to-be-selected performance point at which an energy efficiency level of the range hood is higher than or equal to a target level; and
   determining a target operation parameter of the range hood based on the target performance point.

2. The testing method according to claim 1, wherein the determining the target performance point from the M to-be-selected performance points based on the predetermined power and the fan efficiency comprises:

   determining an energy efficiency level of the range hood corresponding to each of the M to-be-selected performance points based on the predetermined power and the fan efficiency corresponding to each of the M to-be-selected performance points; and
   selecting a to-be-selected point from the M to-be-selected performance points at which the energy efficiency level is higher than or equal to the target level as the target performance point.

3. The testing method according to claim 1 or 2, wherein the performing the constant power control on the fan based on the predetermined power comprises:

   acquiring a control current based on the predetermined power;
   acquiring a feedback current and a feedback voltage of a motor of the fan by controlling, based on the control current and the predetermined power, the motor; and
   determining, based on the feedback current and the feedback voltage, that the fan is under the constant power control.

4. The testing method according to claim 3, wherein the obtaining the feedback current and the feedback voltage of the motor of the fan by controlling, based on the control current and the predetermined power, the motor comprises:

   running the motor of the fan based on the control current and the predetermined power;
   acquiring a real-time rotational speed and a real-time current of the motor; and
   acquiring the feedback current and the feedback voltage in accordance with a determination that the real-time rotational speed and the real-time current satisfy a predetermined condition.

5. The testing method according to claim 3, wherein the feedback current comprises a quadrature-axis current and a direct-axis current, and the feedback voltage comprises a quadrature-axis voltage and a direct-axis voltage; and the determining, based on the feedback current and the feedback voltage, that the fan is under the constant power control comprises:

   acquiring an active power of the motor based on the quadrature-axis current and the quadrature-axis voltage;
   acquiring a reactive power of the motor based on the direct-axis current and the direct-axis voltage;
   acquiring a total power of the motor based on the active power and the reactive power; and
   determining, when the total power and the predetermined power satisfy a predetermined relationship, that the fan is under the constant power control.

6. The testing method according to any one of claims 1 to 5, wherein the performing the constant power control on the fan of the range hood based on the predetermined power and obtaining the M to-be-selected performance points of the fan and the fan efficiency corresponding to each of the M to-be-selected performance points comprises:

   performing the constant power control on the fan of the range hood based on the predetermined power and obtaining a first mapping relationship of the fan at the predetermined power, the first mapping relationship comprising N sets of data pairs of the air volumes and the air pressures, where $N \geq 2$ and N is an integer;
   determining, based on the first mapping relationship and the predetermined power, fan efficiency associated with each of the N sets of data pairs; and
determining as the to-be-selected performance point a data pair at which the fan efficiency satisfies the predetermined condition.

7. The testing method according to claim 6, wherein the predetermined power comprises P testing powers, where P $\geq$ 2 and P is an integer; and
the performing the constant power control on the fan of the range hood based on the predetermined power and obtaining the first mapping relationship of the fan at the predetermined power comprises:
performing the constant power control on the fan based on each of the P testing powers and obtaining a sampling dataset of the air volumes and the air pressures of the fan at each of the P testing powers, and determining all the sampling datasets as the first mapping relationship, one of the sampling datasets comprising a plurality of sets of data pairs of the air volumes and the air pressures.

8. The testing method according to any one of claims 1 to 7, wherein the determining the target operation parameter of the range hood based on the target performance point comprises:

obtaining an actual operation current or an actual rotational speed of the fan when the fan operates at the target performance point; and
determining the actual operation current or the actual rotational speed as the target operation parameter, the actual operation current being used for the constant current control on the range hood, and the actual rotational speed being used for constant rotational speed control on the range hood.

9. The testing method according to any one of claims 1 to 8, further comprising:

controlling, based on the target operation parameter, the fan of the range hood to constantly operate at the target operation parameter;
obtaining a second mapping relationship of the range hood, the second mapping relationship represents a relationship between the air volume and the air pressure of the range hood; and
verifying that the energy efficiency level of the range hood reaches the target level when the second mapping relationship and the target performance point satisfy a predetermined corresponding condition.

10. A testing apparatus for a range hood, the testing apparatus comprising:

an obtaining module configured to perform constant power control on a fan of the range hood based on a predetermined power and obtain M to-be-selected performance points of the fan and fan efficiency corresponding to each of the M to-be-selected performance points , the to-be-selected performance point being a data pair of an air volume and an air pressure of the fan when the fan efficiency satisfies a predetermined condition, where M $\geq$ 1 and M is an integer;
a first determination module configured to select a target performance point from the M to-be-selected performance points based on the predetermined power and the fan efficiency, the target performance point being a to-be-selected performance point at which an energy efficiency level of the range hood is higher than or equal to a target level; and
a second determination module configured to determine a target operation parameter of the range hood based on the target performance point.

11. A testing device for a range hood, the testing device comprising:

a memory;
a processor; and
a computer program stored on the memory and executable on the processor,
wherein the processor, when executing the program, implements the testing method according to any one of claims 1 to 9.

12. A range hood, comprising:

a fan; and
the testing device according to claim 11.

Performing constant power control on a fan of the range hood based on a predetermined power and obtaining M to-be-selected performance points of the fan and fan efficiency corresponding to each of the M to-be-selected performance points, in which the to-be-selected performance point is a data pair of an air volume and an air pressure of the fan when the fan efficiency satisfies a predetermined condition, where M ≥ 1 and M is an integer

S101

Selecting a target performance point from the M to-be-selected performance points based on the predetermined power and the fan efficiency, in which the target performance point is a to-be-selected performance point at which an energy efficiency level of the range hood is higher than or equal to a target level

S102

Determining a target operation parameter of the range hood based on the target performance point

S103

FIG. 1

FIG. 2

FIG. 3

FIG. 4

FIG. 5

FIG. 6

## INTERNATIONAL SEARCH REPORT

| International application No. |
|---|
| **PCT/CN2022/083943** |

| A. | CLASSIFICATION OF SUBJECT MATTER |
|---|---|

G01R 31/00(2006.01)i;  F04D 27/00(2006.01)i;  F24C 15/20(2006.01)i

According to International Patent Classification (IPC) or to both national classification and IPC

| B. | FIELDS SEARCHED |
|---|---|

Minimum documentation searched (classification system followed by classification symbols)

G01R;F04D;F24C

Documentation searched other than minimum documentation to the extent that such documents are included in the fields searched

Electronic data base consulted during the international search (name of data base and, where practicable, search terms used)

CNKI; CJFD; CNABS; CNTXT: 油烟机, 风扇, 发动机, 功率, 风量, 风压, 性能; VEN; DWPI; SIPOABS: smoke, absorb+, fan, motor, power, pressure, efficiency;

| C. | DOCUMENTS CONSIDERED TO BE RELEVANT |
|---|---|

| Category* | Citation of document, with indication, where appropriate, of the relevant passages | Relevant to claim No. |
|---|---|---|
| PX | CN 113687175 A (FOSHAN SHUNDE MIDEA WASHING APPLIANCES MFG CO., LTD.) 23 November 2021 (2021-11-23) claims 1-12 | 1-12 |
| A | CN 104121217 A (FOSHAN SHUNDE WANHE ELECTRIC PARTS CO., LTD.) 29 October 2014 (2014-10-29) description, paragraphs [0015]-[0024], and figure 1 | 1-12 |
| A | CN 103836691 A (GUANGDONG WELLING MOTOR MANUFACTURING CO., LTD.) 04 June 2014 (2014-06-04) entire document | 1-12 |
| A | CN 1459054 A (HUONELL INTERNAT AB) 26 November 2003 (2003-11-26) entire document | 1-12 |
| A | CN 103216867 A (HUADI GAS RANGES CO., LTD., ZHONGSHAN) 24 July 2013 (2013-07-24) entire document | 1-12 |
| A | US 6397321 B1 (YAMAHA CORP.) 28 May 2002 (2002-05-28) entire document | 1-12 |

☐ Further documents are listed in the continuation of Box C.   ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **29 June 2022** | **06 July 2022** |

| Name and mailing address of the ISA/CN | Authorized officer |
|---|---|
| **China National Intellectual Property Administration (ISA/ CN)** **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

INTERNATIONAL SEARCH REPORT
Information on patent family members

International application No.

**PCT/CN2022/083943**

| Patent document cited in search report | | | Publication date (day/month/year) | Patent family member(s) | | | Publication date (day/month/year) |
|---|---|---|---|---|---|---|---|
| CN | 113687175 | A | 23 November 2021 | None | | | |
| CN | 104121217 | A | 29 October 2014 | None | | | |
| CN | 103836691 | A | 04 June 2014 | None | | | |
| CN | 1459054 | A | 26 November 2003 | SE | 0003339 | D0 | 18 September 2000 |
| | | | | AU | 9041401 | A | 26 March 2002 |
| | | | | EP | 1887449 | A2 | 13 February 2008 |
| | | | | US | 2004101412 | A1 | 27 May 2004 |
| | | | | WO | 0223298 | A1 | 21 March 2002 |
| | | | | AT | 514126 | T | 15 July 2011 |
| | | | | EP | 1320789 | A1 | 25 June 2003 |
| | | | | JP | 2004509272 | A | 25 March 2004 |
| | | | | RU | 2310222 | C2 | 10 November 2007 |
| CN | 103216867 | A | 24 July 2013 | None | | | |
| US | 6397321 | B1 | 28 May 2002 | TW | 516020 | B | 01 January 2003 |
| | | | | JP | 2000057122 | A | 25 February 2000 |

Form PCT/ISA/210 (patent family annex) (January 2015)

**EP 4 318 000 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202111131743